# EUROPÄISCHE PATENTANMELDUNG

(11) **EP 0 889 522 A2**
(43) Veröffentlichungstag der Anmeldung: **07.01.1999**
(21) Anmeldenummer: 98110855.8
(22) Anmeldetag: 13.06.1998
(51) Int. Cl.: H01L 23/10

(54) **Keramikgehäuse und Verfahren zu seiner Herstellung**

(30) Priorität: 01.07.1997 DE 19727913
(71) Anmelder: DAIMLER-BENZ AKTIENGESELLSCHAFT, 70567 Stuttgart (DE)
(72) Erfinder: Krüger, Reinhard, Dipl.-Ing., 91056 Erlangen (DE); Schaper, Wolfgang, Dr., 63150 Heusenstamm (DE); Roosen, Andreas, Prof. Dr., 65719 Hofheim (DE)
(74) Vertreter: Maute, Hans-Jürgen, Dipl.-Ing.

(57) **Zusammenfassung**

Die Erfindung betrifft ein Keramikbauelement, insbesondere zum Kapseln von elektronischen Bauelementen, welches ein Verbindungsmaterial (3) und zu verbindende Keramik-Fügeteile (1, 2) aufweist, wobei die Fügeteile (1, 2) durch ein Glaslot (3) mit einer Verarbeitungstemperatur von mehr als 500°C und weniger als 800°C verbunden sind.

## Beschreibung

Die Erfindung betrifft ein Keramikgehäuse zum Kapseln von elektronischen Bauelementen und ein Verfahren zum Herstellen eines Keramikgehäuses.

Es ist bekannt, integrierte elektronische Schaltungen mit Keramikgehäusen zu kapseln. Der Vorteil liegt darin, daß diese Kapselung sowohl besonders gut gegen das Eindringen von Feuchtigkeit und Gas schützt als auch eine hohe elektrische Isolierfähigkeit besitzt. Geeignete Keramikmaterialien sind insbesondere Aluminiumoxid oder Aluminiumnitrid. Der Zusammenfügen der Keramikgehäuse erfolgt durch Kleben oder Löten für den Einsatz bei niedrigen Betriebstemperaturen bis 200°C.

Bei Temperaturen oberhalb von 200°C zersetzt sich der Kleber oder das Verbindungsmittel zwischen den Keramik-Fügeteilen. Für den Einsatz bei hohen Temperaturen von über 200°C kann zwar das Aktivlöten mit einem Metall als Verbindungsmittel eingesetzt werden. Der Nachteil besteht jedoch darin, daß die dazu notwendige Prozeßtemperatur von über 900°C die zu kapselnde Elektronik zerstört.

Der Erfindung liegt die Aufgabe zugrunde, ein Keramikgehäuse, insbesondere aus Aluminiumnitrid, anzugeben, welches zum hermetischen Kapseln von elektronischen Bauelementen für erhöhte Betriebstemperaturen geeignet ist, sowie ein Verfahren zu seiner Herstellung.

Die Aufgabe wird durch die Merkmale der unabhängigen Ansprüche gelöst. Weiterführende und vorteilhafte Ausgestaltungen sind den Unteransprüchen und der Beschreibung zu entnehmen.

Für den Einsatz von neuartigen elektronischen Hochtemperatur-Bauelementen sind höhere Einsatztemperaturen zwischen 200°C und 700°C vorgesehen. Zum Kapseln sind Gehäuse und Verschlußtechniken notwendig, die die Hermetizität auch bei diesen Temperaturen gewährleisten.

Erfindungsgemäß werden die Keramik-Fügeteile, insbesondere aus AlN, mit einem Glaslot verbunden, welches bei Temperaturen verarbeitbar ist, die für die zu kapselnden Elektronikmaterialien noch verträglich sind und eine hermetisch dichte Verbindung der Keramikfügeteile ermöglichen.

Vorteilhafterweise liegt die Verarbeitungstemperatur nur geringfügig oberhalb der maximalen Einsatztemperatur, die bis 700°C heranreicht, ohne daß die Haftung der Fügeteile, die Festigkeit und/oder die Hermetizität der Verbindungsstelle verschlechtert wird.

Bei vorteilhafter Zusammensetzung und Verarbeitung des Glaslots unterbindet eine schädliche, gasentwickelnde Reaktion mit der Keramik. Mit dem Glaslot verbundene Fügeteile können vorteilhafterweise bis nahe an die Verarbeitungstemperatur des Glaslot dauerhaft bei erhöhter Temperatur gehalten werden, ohne daß die Verbindungsstelle weich oder undicht wird. Dies ist vorteilhaft für keramische Gehäuse von Hochtemperatur-Halbleiterbauelementen, welche bei Temperaturen über 500°C eingesetzt werden und durch das keramische Gehäuse hermetisch geschützt sein sollen.

Besonders bevorzugt werden Glaslote eingesetzt, insbesondere Glaslot mit einer Zusammensetzung, die keine gasbildenden Reaktionen mit den Keramikfügeteilen im Verarbeitungsbereich hervorruft.

Vorteilhaft ist, wenn die Zusammensetzung des Glaslots eine Bleioxidkonzentration von weniger als 1 Gewichtsprozent aufweist. Besonders vorteilhaft ist, daß das Glaslot im wesentlichen frei von Alkalimetalloxiden ist und einen thermischen Ausdehnungskoeffizienten aufweist, der dem der keramischen Fügeteile weitgehend entspricht.

Besonders bevorzugt weist das Glaslot eine Zusammensetzung der Einwaage von 62,5% ZnO, 25% B₂O₃, 12,5% SiO₂ auf. Eine weitere bevorzugte Zusammensetzung enthält in der Einwaage 60% ZnO, 10% SiO₂, 25% B₂O₃, 3% Ta₂O₅, 1% Al₂O₃.

In einem erfindungsgemäßen Verfahren werden Fügeteile zusammengefügt, indem eine homogene Paste aus Glasfritte auf ein erstes Fügeteil aufgebracht, die Paste nach dem Austreiben der organischen Komponente mit dem ersten Fügeteil bei einer ersten Temperatur für eine erste Zeitdauer vorverglast, anschließend das erste Fügeteil mit Glasfrittenbeschichtung und ein zweites Fügeteil in Anlage gebracht, auf eine zweite erhöhte Temperatur für eine zweite Zeitdauer erhitzt und das erste mit dem zweiten Fügeteil verbunden wird.

In einem weiteren erfindungsgemäßen Verfahren werden eines oder beide Fügeteile mit Paste bestrichen, zusammengefügt, erhitzt und mit dem vorverglasten Glaslot verbunden.

In einer vorteilhaften Ausführung werden der Glasfritte Kristallisationskeime beigegeben. Der Vorteil ist, daß durch eine gezielte Auskristallisation von Bestandteilen des Glaslots das Fließen und Weichwerden des Lots bei erhöhten Betriebstemperaturen bis nahe an die Verarbeitungstemperatur unterbunden wird.

Besonders bevorzugt ist, beim Verbinden der Fügeteile zusätzlich einen Druck auf die Fügeteile auszuüben. Beim Zusammenfügen der Fügeteile wird das Glaslot besser verteilt und die Porosität des Glaslots stark vermindert.

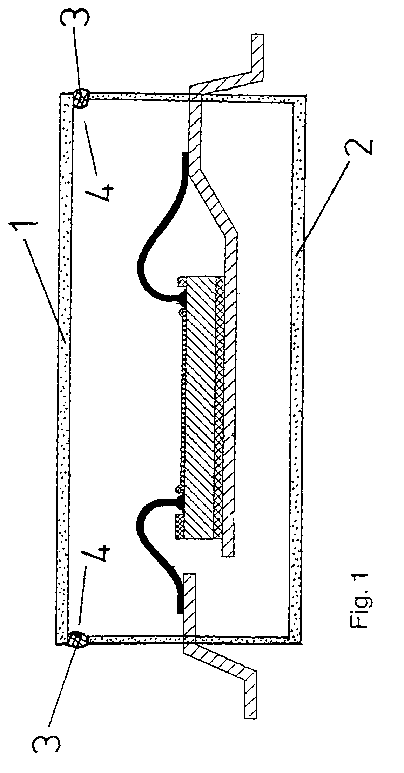

Im folgenden sind die Merkmale, soweit sie für die Erfindung wesentlich sind, eingehend erläutert und anhand von einer Prinzipskizze näher beschrieben. Die Prinzipskizze (Fig. 1) zeigt ein erfindungsgemäßes Gehäuse zum Kapseln von elektronischen Halbleiterbauelementen.

Fig. 1 zeigt ein erfindungsgemäßes Keramikgehäuse mit einem eingebauten elektronischen Bauelement. Ein Fügeteil 1 ist mit einem Fügeteil 2 mit einem Verbindungsmittel 3 an angepaßte Verbindungsstellen 4 verbunden. Im Innern des Keramikgehäuses befindet sich das zu schützende elektronische Bauelement, welches vorzugsweise aus einem Hochtemperatur-Material, insbesondere Siliziumkarbid oder dergl. gebildet ist. Das erfindungsgemäße Keramikgehäuse für mikroelektronische Hochtemperaturbauelemente ist für eine Anwendungstemperatur bis 700°C geeignet.

Das erfindungsgemäße Herstellverfahren ist insbesondere für Aluminiumnitridgehäuse geeignet, die Erfindung ist jedoch nicht auf dieses Keramikmaterial beschränkt. Besonders bei Aluminiumnitridgehäusen tritt das Problem auf, daß sich oberhalb von 500°C zwischen der Keramik und dem Verbindungsmittel gasbildende Reaktionen entwickeln können, so daß die Verbindungsstelle undicht wird oder sich die Verbindung vollständig löst.

Das erfindungsgemäße Verbindungsmittel unterbindet gasbildende Reaktionen an der Verbindungsstelle der Fügeteile. Das Verbindungsmittel greift die Keramik der Fügeteile nicht korrosiv an.

Erfindungsgemäß werden die keramischen Fügeteile mit einem Glasot verbunden. Vorzugsweise weist das Gemenge des Glaslots einen Anfangsgehalt der Einwaage von 12,5% SiO₂, 25% B₂O₃ und 62,5% ZnO in Gewichtsprozent auf. Die Komponenten Si, Zn und B sind als Glasbildner wirksam. Das Glaslot dieser Zusammensetzung weist bereits ein Auskristallisieren des Glaslots während des Fügeprozesses auf, welches den Vorteil mit sich bringt, daß das Glaslot dauerhaft bis nahe an seine Verarbeitungstemperatur thermisch belastbar ist, ohne daß die Verbindungsstelle undicht wird.

Bei einer weiteren bevorzugten Zusammensetzung weist das Gemenge des Glaslots einen Anfangsgehalt der Einwaage von 3% Ta₂O₅, 1% Al₂O₃, 10% SiO₂, 25% B₂O₃ und 60% ZnO in Gewichtsprozent auf. Die Zugabe von Al₂O₃ verbessert vorteilhaft die chemische Beständigkeit des Glaslots. Die Zugabe von Ta₂O₅ verlangsamt vorteilhaft die Kristallisationsgeschwindigkeit während des Fügeprozesses, so daß dieser Vorgang steuerbar wird und verbessert zudem günstigerweise die Benetzungeigenschaften des Glaslots auf der Keramik.

Wesentlich ist, daß der Gehalt an Bleioxid gering ist, wenigstens weniger als 1 Gewichtsprozent, besonders bevorzugt ist, daß das Glaslot keinen Gehalt an Bleioxid aufweist. Selbst bei einer Auslagerung eines damit verlöteten Bauelements über mehrere hundert Stunden bei einer Bauelementtemperatur von etwa 650°C zeigte sich an den Fügestellen keine erkennbare Porenbildung.

Übliche Glaslote enthalten Bleioxid, da dieses das Aufschmelzverhalten des Glaslotes verbessert. Selbst bei relativ geringen Bleioxid-Gehalten von nur 3 Gewichtsprozent wird bei einem ähnlichen Auslagerungsversuch eine schädliche, korrosive Reaktion zwischen dem Glaslot und der Keramik, bei der insbesondere Stickstoff aus dem Aluminiumnitrid freigesetzt wird, beobachtet An der Verbindungsstelle bilden sich Poren und die Fügeteile lösen sich voneinander.

Ein Verzicht auf Bleioxid in einem Glaslot bedeutet an sich eine stark erhöhte Verarbeitungstemperatur, die für die erlaubten maximalen Verarbeitungstemperaturen unter etwa 800°C zu hoch ist. Die Zusammensetzung des erfindungsgemäßen Glaslots erlaubt trotzdem eine verringerten Verarbeitungstemperatur von unter 800°C, insbesondere 700-750°C.

Günstig ist, den Alkalimetalloxidgehalt des Glaslots so gering wie möglich zu halten. Zwar senkt ein Alkalimetalloxidgehalt die Schmelztemperatur der Glasfritte, jedoch führt dies bei einem etwaigen zu kapselnden elektronischen Halbleiterbauelement zu unerwünschter Kontaminationen mit Alkalimetallen, welche im Halbleiterkörper schnell diffundieren und unerwünschte Dotierungen im Halbleiterbauelement bilden können. Außerdem steigt der thermische Ausdehnungskoeffizient des Glaslots mit dem Alkalimetalloxidgehalt. Bei alkalimetalloxidfreiem Glaslot liegt der thermische Ausdehnungskoeffizient etwa bei 3,5·10⁻⁶ bis 4·10⁻⁶ 1/K.

Zum erfindungsgemäßen Verbinden von keramischen Fügeteilen wird zuerst eine Mischung von bleioxidfreien, vorzugsweise zusätzlich alkalimetalloxidfreien, Oxidpulvern in eine homogene Schmelze verwandelt. Dazu wird die Oxidmischung bevorzugt in einem Platintiegel auf vorzugsweise 1300°C bis zum Entstehen einer homogenen Schmelze erhitzt. Die Schmelze wird abgeschreckt, wobei darauf geachtet werden muß, daß die Schmelze nicht mit Wasser in Berührung kommt, um einen hydrolytischen Angriff zu vermeiden. Das entstandene Glas wird anschließend zu einer Glasfritte fein zermahlen, bevorzugt mit einer mittleren Korngröße von höchstens 12 µm, besonders von höchstens etwa 5 µm.

Zweckmäßigerweise können der feingemahlenen Glasfritte Kristallkeime zugegeben werden, insbesondere etwa 2 Gewichtsprozent, die das Kristallistationsverhalten des Glaslots verbessern. Vorzugsweise weisen die Kristallkeime verschiedene Gehalte an Boroxid und/oder Siliziumoxid auf, insbesondere ZnO·2B₂O₃, ZnO·B₂O₃, 3ZnO·B₂O₃ und/oder 2 ZnO·SiO₂. Da diese Komponenten auch anschließend im Fügeprozeß aus dem Glaslot auskristallisieren, kann das Kristallisationsverhalten durch Zugabe der Kristallisationskeime günstig gesteuert werden.

Die Fritte wird anschließend mit einer organischen Komponente zu einer homogenen Paste verarbeitet. Die organische Komponente ist insbesondere ein Gemisch aus iso- oder α-Terpineol und einem Isobutylmethacrylat (z.B. Elvacite 2045 der Firma DuPont). Die Paste bildet das Verbindungsmittel 3, welches auf ein erstes zu verbindendes Fügeteil 1, insbesondere einen Keramik-Gehäusedeckel, aufgebracht wird. Das Auftragen kann durch Aufstreichen, bevorzugt durch Rakeln oder Siebdruck erfolgen.

Das Gehäuse selbst kann vorzugsweise bereits gasdichte elektrische Durchführungen aufweisen. Es ist jedoch auch möglich, elektrische Durchführungen mittels des Glaslots gasdicht in etwaige Gehäusedurchführungen einzukleben oder einzulöten.

Durch Erhitzen der Paste wird die organische Komponente ausgetrieben und anschließend vorverglast. Dazu wird das erste Fügeteil langsam auf eine erste Temperatur über 600°C, insbesondere 650°C aufgeheizt und dort eine erste Zeitdauer gehalten, vorzugsweise länger als 10 Minuten, besonders bevorzugt 20 Minuten. Durch Verdichtung der Glaskömer bildet sich eine kompakte Glasschicht an der Verbindungsstelle, welche gut handhabbar ist. Anschließend wird das erste Fügeteil und/oder ein zweites Fügeteil, insbesondere ein Unterteil eines Keramikgehäuses, in das ein elektronisches Halbleiterbauelement eingesetzt ist, durch erneutes Erhitzen und Aufschmelzen des Glaslots auf eine zweite Temperatur über der ersten Temperatur erhitzt, für eine vorgegebene zweite Zeitdauer bei der zweiten erhöhten Temperatur gehalten und dabei das erste Fügeteil 1 mit dem zweiten Fügeteil 2 verbunden. Die zweite Temperatur liegt bevorzugt bei etwa 700°C, die zweite Zeitdauer ist bevorzugt länger als 15 Minuten, vorzugsweise bei 30 Minuten. Dabei werden die beiden Fügeteile aufeinander gelegt und miteinander verbunden. Durch Erhöhung der Fügetemperatur kann die Fügezeit vorteilhaft verkürzt werden. Zweckmäßigerweise werden Fügetemperatur und Fügedauer so aufeinander abgestimmt, daß das zu kapselnde Bauelemenent möglichst schonend behandelt wird.

Beim Zusammenfügen der beiden Fugeteile können diese vorzugsweise mit einem Druck zwischen 10 bis 100 kPa zusammengepreßt werden. Dies unterstützt vorteilhaft das Fließen des Glases beim Fügevorgang. Zudem verringert sich vorteilhaft eine etwaige Porosität des Glaslots.

In einem weiteren bevorzugten Verfahren werden das erste und/oder zweite Fügeteil mit der Paste bestrichen, zusammengefügt und dann erst erhitzt, wobei die organische Komponente aus der Paste ausgetrieben, das Glaslot vorverglast und die Fügeteile miteinander verbunden werden.

Die Zugabe der Kristallisationskeime bei der Zubereitung der Glasfritte ist besonders vorteilhaft, da die Verbindung damit auch nahe der Verarbeitungstemperatur dauerhaft belastbar ist, ohne weich zu werden oder sich zu lösen. Die Kristallisationskeime führen zur kontrollierten Umwandlung des Glaslots zu einer Glaskeramik, die besonders fest ist. Während das reine Glaslot nur äußerst langsam und unkontrolliert kristallisiert und bei höheren Temperaturen über 600°C bereits weich wird, führt das Auskristallisieren des Glaslots, das durch die Kristallisationskeime initiiert wurde, insbesondere Zinkborat und/oder Zinksilikat, zu einer drastischen Verringerung der Fließfähigkeit des Glases. Die auskristallisierten Bestandteile weisen zudem einen vorteilhaften thermischen Ausdehnungskoeffizienten im Bereich von 3,5·10⁻⁶ bis 4·10⁻⁶ 1/K auf.

Damit ist es möglich, ein erfindungsgemäßes Keramik-Gehäuse bei einer Dauerbetriebstemperatur von 650°C sicher zu betreiben, obwohl das Glaslötverfahren bei einer Verarbeitungstemperatur von nur 700°C durchgeführt wurde.

## Patentansprüche

1. Keramikbauelement, insbesondere zum Kapseln von elektronischen Bauelementen, welches ein Verbindungsmaterial und zu verbindende Keramik-Fügeteile aufweist, **dadurch gekennzeichnet,**
daß die Fügeteile (1, 2) durch ein Glaslot (3) mit einer Verarbeitungstemperatur von mehr als 500°C und weniger als 800°C verbunden sind.

2. Keramikgehäuse nach Anspruch 1,
dadurch gekennzeichnet,
daß das Gemenge des Glaslots einen PbO-Anfangsgehalt der Einwaage von weniger als 1 Gewichtsprozent aufweist.

3. Keramikgehäuse nach Anspruch 1 oder 2,
dadurch gekennzeichnet,
daß das Gemenge des Glaslots einen Alkalioxid-Anfangsgehalt der Einwaage von weniger als 0,5 Gewichtsprozent aufweist.

4. Keramikgehäuse nach einem oder mehreren der vorausgegangenen Ansprüche,
dadurch gekennzeichnet,
daß das Gemenge des Glaslots einen ZnO-Anfangsgehalt der Einwaage von mehr als 40 Gewichtsprozent aufweist.

5. Keramikgehäuse nach einem oder mehreren der vorausgegangenen Ansprüche,
dadurch gekennzeichnet,
daß das Gemenge des Glaslots einen SiO₂-Anfangsgehalt der Einwaage von mehr als 5 Gewichtsprozent aufweist.

6. Keramikgehäuse nach einem oder mehreren der vorausgegangenen Ansprüche,
dadurch gekennzeichnet,
daß das Gemenge des Glaslots einen Ta₂O₅-Anfangsgehalt der Einwaage von mehr als 0,5 Gewichtsprozent aufweist.

7. Keramikgehäuse nach einem oder mehreren der vorausgegangenen Ansprüche,
dadurch gekennzeichnet,
daß das Gemenge des Glaslots einen Al₂O₃-Anfangsgehalt der Einwaage von mehr als 0,5 Gewichtsprozent aufweist.

8. Keramikgehäuse nach einem oder mehreren der vorausgegangenen Ansprüche,
dadurch gekennzeichnet,
daß das Gemenge des Glaslots einen B₂O₃-Anfangsgehalt der Einwaage von mehr als 10 Gewichtsprozent aufweist.

9. Keramikgehäuse nach einem oder mehreren der vorausgegangenen Ansprüche,
dadurch gekennzeichnet,
daß das Gemenge des Glaslots jeweils einen Anfangsgehalt in der Einwaage von 3% Ta₂O₅, 1% Al₂O₃ , 10% SiO₂, 25% B₂O₃, und 60% ZnO in Gewichtsprozent aufweist.

10. Keramikgehäuse nach einem oder mehreren der vorausgegangenen Ansprüche 1-8,
dadurch gekennzeichnet,
daß das Gemenge des Glaslots jeweils einen Anfangsgehalt in der Einwaage von 12,5% SiO₂, 25% B₂O₃, und 62,5% ZnO in Gewichtsprozent aufweist.

11. Keramikgehäuse nach einem oder mehreren der vorausgegangenen Ansprüche,
dadurch gekennzeichnet,
daß das Glaslot einen thermischen Ausdehnungskoeffizienten von weniger als 5·10⁻⁶/K aufweist.

12. Keramikgehäuse nach einem oder mehreren der vorausgegangenen Ansprüche,
dadurch gekennzeichnet,
daß das Gehäuse Aluminiumnitrid aufweist.

13. Verfahren zum Verbinden von Fügeteilen aus Keramik, insbesondere nach Anspruch 1 oder einen oder mehreren der folgenden,
dadurch gekennzeichnet,
daß eine Paste aus einer Mischung aus Glasfritte und organischer Komponente auf ein erstes zu verbindendes Fügeteil aufgebracht wird, daß die Paste nach Austreiben der organischen Komponente vorverglast wird, indem das erste Fügeteil auf eine erste Temperatur über 600°C aufgeheizt und dort eine erste Zeitdauer gehalten wird, anschließend das erste Fügeteil mit einem zweiten Fügeteil auf Anschlag gebracht, auf eine zweite Temperatur über der ersten Temperatur erhitzt, für eine vorgegebene zweite Zeitdauer bei der zweiten Temperatur gehalten wird und dabei das erste Fügeteil mit dem zweiten Fügeteil verbunden wird.

14. Verfahren nach Anspruch 13,
dadurch gekennzeichnet,
daß das erste und/oder das zweite Fügeteil mit der Paste bestrichen, auf Anschlag gebracht, auf eine erste Temperatur über 600°C aufgeheizt und dort eine erste Zeitdauer gehalten wird, anschließend auf eine zweite Temperatur über der ersten Temperatur erhitzt, für eine vorgegebene zweite Zeitdauer bei der zweiten Temperatur gehalten und dabei das erste Fügeteil mit dem zweiten Fügeteil verbunden wird.

15. Verfahren nach Anspruch 13 oder 14,
dadurch gekennzeichnet,
daß die Glasfritte aus einer Mischung von bleioxidfreien Oxidpulvern hergestellt wird, welche in eine homogene Schmelze verwandelt und abgeschreckt und anschließend das entstandene Glas anschließend fein zur Glasfritte gemahlen wird.

16. Verfahren nach Anspruch 13, 14 oder 15,
dadurch gekennzeichnet,
daß der Glasfritte Kristallkeime zugegebene werden.

17. Verfahren nach einem oder mehreren der vorausgegangenen Ansprüche 13 bis 16,
dadurch gekennzeichnet,
daß die erste Temperatur zwischen 600°C und 700°C liegt.

18. Verfahren nach einem oder mehreren der vorausgegangenen Ansprüche 13 bis 17,
dadurch gekennzeichnet,
daß die zweite Temperatur zwischen 650°C und 800°C liegt.

19. Verfahren nach einem oder mehreren der vorausgegangenen Ansprüche 13 bis 18,
dadurch gekennzeichnet,
daß die erste Zeitdauer länger als 10 Minuten dauert.

20. Verfahren nach einem oder mehreren der vorausgegangenen Ansprüche 13 bis 19,
dadurch gekennzeichnet,
daß die zweite Zeitdauer länger als 15 Minuten dauert.

21. Verfahren nach einem oder mehreren der vorausgegangenen Ansprüche 13 bis 20,
dadurch gekennzeichnet,
daß beim Verbinden des ersten mit dem zweiten Fügeteil ein Druck auf die beiden Fügeteile ausgeübt wird.

22. Verfahren nach Anspruch 21,
dadurch gekennzeichnet,
daß der Druck im Bereich zwischen 10 und 100 kPa ausgeübt wird.
